# EUROPEAN PATENT APPLICATION

(11) **EP 4 318 600 A1**
(43) Date of publication of application: **07.02.2024**
(21) Application number: 22872114.8
(22) Date of filing: 23.09.2022
(51) Int. Cl.: H01L 31/0216, H01L 31/0236, H01L 31/068, H01L 31/18, C30B 29/06, C30B 33/10

(54) **TEXTURE STRUCTURE OF SOLAR CELL AND PREPARATION METHOD THEREFOR**

(30) Priority: 23.09.2021 CN 202111114953
(71) Applicant: Trina Solar Co., Ltd, Changzhou, Jiangsu 213000 (CN)
(72) Inventor: CHEN, Hong, Hangzhou, Jiangsu 213000 (CN); LI, Hancheng, Hangzhou, Jiangsu 213000 (CN); GAO, Jifan, Hangzhou, Jiangsu 213000 (CN); CHEN, Yifeng, Hangzhou, Jiangsu 213000 (CN)
(74) Representative: Canzler & Bergmeier Patentanwälte Partnerschaft mbB
(86) International application number: PCT/CN2022/120880
(87) International publication number: WO 2023/046070

(57) **Abstract**

The present invention provides a texture structure of a solar cell and a preparation method therefor. The texture structure comprises a texture; a texture surface comprises a contact region and a non-contact region; the contact region is provided with a metal gate line; the specific surface area of the contact region is less than that of the non-contact region. According to the texture structure of a solar cell and the preparation method therefor provided by the present invention, texture structures having different microscopic morphologies are formed on the texture of a metal gate line coverage region and the texture of a metal gate line non-coverage region, and the specific surface area of the texture structure in the non-coverage region is much greater than that of the texture structure in the coverage region, thereby reducing the contact area between slurry metal and the PN junction on the texture, reducing metal compounding by more than 20%, and improving conversion efficiency.

## Description

### TECHNICAL FIELD

The present disclosure relates to the technical field of solar cells, and specifically relates to a texture structure of a solar cell and a preparation method therefor.

### BACKGROUND

The solar cell, as a semiconductor component, can convert solar energy into electric energy, and the monocrystalline silicon solar cell has the highest conversion efficiency among silicon based solar cells, and is most mature in technology. The monocrystalline silicon is a kind of rod-shaped monocrystalline silicon which is grown from amorphous silicon or polycrystalline silicon in melt through a Czochralski method or a float zone method, and requires a purity of 99.9999% or more. The process for preparing a monocrystalline silicon solar cell generally includes: (1) obtaining a surface appearance of a pyramid structure by corroding a silicon wafer anisotropically in an alkaline solution; (2) forming a PN junction through high-temperature phosphorus diffusion; (3) performing plasma etching on an edge of the diffused silicon wafer using SF₄ and O₂ as raw materials, to prevent short circuit of the cell; (4) removing phosphorosilicate glass from the surface of the silicon wafer by HF; (5) depositing an antireflection passivation film on the surface of the silicon wafer by a PECVD process; (6) printing a back electrode, a back electric field and a positive electrode; and (7) sintering.

The surface texturing technique of the monocrystalline silicon solar cell is an important step in the preparation of modern solar cells, and by forming a pyramid-shaped line-surface structure on the surface of the solar cell through a chemical corrosion process, the reflectivity of the surface of the solar cell can be greatly reduced, and the density of photogenerated carriers is increased, so that the aims of improving the energy conversion efficiency of the cell and reducing the production cost are fulfilled.

CN102148292B discloses a method for preparing a solar cell texture, where the solar cell texture is formed on a surface of the solar cell silicon wafer on a light receiving surface side, and the method includes transferring, before a texturing process is initiated, a mask material on a pre-prepared pattern template to a surface of a solar cell silicon wafer in an imprinting manner through nano-imprinting, to form a mask layer for the texturing process, and then texturing through a wet etching or plasma etching process.

CN112768555A discloses a method for manufacturing a solar cell texture, including: a pre-cleaning step of placing a solar cell chip in a mixed solution for surface cleaning; a damage removal step; a first cleaning step between the damage removal step and a fast large texture step; the fast large texture step; large texture sharp top processing step; a second cleaning step between the large texture sharp top processing step and a small texture growing step; the small texture growing step; a third cleaning step after the small texture growing step; a pre-dewatering step after the third cleaning step; and a heating and drying step after the pre-dewatering step.

CN103441182A discloses a method for processing a texture of a solar cell and a solar cell. The method includes: primarily cleaning a texture of a textured solar cell with a mixed aqueous solution of HCl and HF, where in the mixed aqueous solution of HCl and HF, a mass fraction of HCl is 3% to 7%, and a mass fraction of HF is 1% to 2%; etching the primarily cleaned texture with a mixed aqueous solution of HNO₃ and HF, where in the mixed aqueous solution of HNO₃ and HF, a mass fraction of HNO₃ is 20% to 50%, and a mass fraction of HF is 0.5% to 5%; oxidizing the etched texture with a mixed aqueous solution of H₂SO₄ and H₂O₂ to form an oxide layer, where in the mixed aqueous solution of H₂SO₄ and H₂O₂, a mass fraction of H₂SO₄ is 60% to 80%, and a mass fraction of H₂O₂ is 5% to 12%.

A main function of the texture is light trapping, but when a metal gate line is printed, the texture in a region of the metal gate line will be shielded, and cannot play a role in light trapping any more. A surface with a texture structure has a much larger specific surface area than a surface of a non-texture structure, and increases a contact area between a slurry metal and a PN junction on the texture, but may increase metal recombination and thus lead to a negative effect.

### SUMMARY

Aiming at the defects in the existing technology, an object of the present disclosure is to provide a texture structure of a solar cell and a preparation method therefor. According to the texture structure of a solar cell provided in the present disclosure, the texture of a metal gate line coverage region (contact region) and the texture of a metal gate line non-coverage region (non-contact region) form different microscopic appearances of texture structure, and the texture structure in the non-coverage region has a specific surface area much larger than the texture structure in the coverage region, thereby reducing a contact area between a slurry metal and a PN junction on the texture, reducing the metal recombination by more than 20%, and improving the conversion efficiency.

In order to achieve this object, the present disclosure adopts the following technical solutions:

In a first aspect, the present disclosure provides a texture structure of a solar cell, including a texture with a surface including a contact region and a non-contact region, wherein the contact region is provided with a metal gate line, and has a specific surface area smaller than the non-contact region.

According to the texture structure of a solar cell provided in the present disclosure, the texture of a metal gate line coverage region (contact region) and the texture of a metal gate line non-coverage region (non-contact region) form different microscopic appearances of texture structure, and the texture structure in the non-coverage region has a specific surface area much larger than the texture structure in the coverage region, thereby reducing a contact area between a slurry metal and a PN junction on the texture, reducing the metal recombination by more than 20%, and improving the conversion efficiency.

It should be noted that the specific surface area herein refers to a surface area of the texture structure per unit area.

As an optional technical solution of the present disclosure, a PN junction and a passivation layer are sequentially arranged in a stacked manner on the surface of the texture, and the metal gate line is located on a surface of the passivation layer corresponding to the contact region.

Preferably, the texture in the contact region has a greater reflectivity than the texture in the non-contact region.

Optionally, the texture in the contact region has a reflectivity of 8% to 46%, for example, 10%, 12%, 14%, 16%, 18%, 20%, 22%, 24%, 26%, 28%, 30%, 32%, 34%, 36%, 38%, 40%, 42%, 44%, or 46%, but is not limited to the recited values, and other values not recited in this range are also applicable.

Preferably, the texture in the non-contact region has a reflectivity of 5% to 14%, for example, 5%, 6%, 7%, 8%, 9%, 10%, 11%, 12%, 13%, or 14%, but is not limited to the recited values, and other values not recited in this range are also applicable.

As an optional technical solution of the present disclosure, a surface of the non-contact region is an array of irregular structures, and a surface of the contact region is a flat texture.

In the present disclosure, different levels and appearances of planarization treatment are performed on the texture in the contact region, so that a contact area between the metal and the texture, as well as metal recombination, is effectively reduced, while the conversion efficiency of the cell is improved. It should be noted that the term "flat texture" in the present disclosure is a relative concept compared to the array of irregular structures, and means that the surface of the contact region is flatter than the surface of the non-contact region, which may be "flat" in an absolute sense, or may have a gently curved structure.

Optionally, the array of irregular structures includes pyramid protrusions or inverted pyramid depressions across the region, wherein the pyramid protrusions or the inverted pyramid depressions are different in size and distributed at random positions.

Optionally, the contact region is a depressed flat texture.

With the depressed texture of the contact region, the present disclosure can effectively reduce transmission paths of carriers while reducing the contact area between the metal gate line and the texture, and improve the conversion efficiency of the cell.

As an optional technical solution of the present disclosure, the non-contact region is an array of irregular structures, and the contact region is an array of regular structures.

With the regularized texture of the contact region, the present disclosure can make the metal gate line parallel to the array of regular pyramid structures while reducing the contact area between the metal and the texture, so that the metal gate lines can be regularly placed into grooves between the pyramid structures, thereby reducing transmission paths of carriers, broken gates, as well as the contact resistance, while improving the conversion efficiency.

Optionally, the array of irregular structures includes pyramid protrusions or inverted pyramid depressions across the region, wherein the pyramid protrusions or the inverted pyramid depressions are different in size and distributed at random positions.

Optionally, the array of regular structures includes at least two rows of strip-shaped protrusions or strip-shaped grooves parallel to each other.

As an optional technical solution of the present disclosure, each of the non-contact region and the contact region is an array of irregular structures.

Optionally, the array of irregular structures in the contact region includes first pyramid protrusions across the region, the array of irregular structures in the non-contact region includes second pyramid protrusions across the region, and each first pyramid protrusion has a height smaller than any of the second pyramid protrusions.

Optionally, the array of irregular structures in the contact region includes first inverted pyramid depressions across the region, the array of irregular structures in the non-contact region includes second inverted pyramid depressions across the region, and each first inverted pyramid depression has a depth smaller than any of the second inverted pyramid depressions.

Optionally, the array of irregular structures in the contact region includes third pyramid protrusions across the region, the array of irregular structures in the non-contact region includes third inverted pyramid depressions across the region, and each third pyramid protrusion has a height smaller than a depth of any of the third inverted pyramid depressions.

Optionally, the array of irregular structures in the contact region includes fourth inverted pyramid depressions across the region, the array of irregular structures in the non-contact region includes fourth pyramid protrusions across the region, and each fourth inverted pyramid depression has a depth smaller than a height of any of the fourth pyramid protrusions.

As an optional technical solution of the present disclosure, a surface of the contact region forms undulant protrusions across the region, a surface of the non-contact region forms irregular pyramid protrusions, and each undulant protrusion has a height smaller than any of the pyramid protrusions.

It should be noted that a core inventive concept of the present disclosure is to form different microscopic appearances of texture structure in the contact region and the non-contact region, so as to reduce a contact area between the metal slurry and the texture structure in the contact region. Therefore, it is to be understood that the specific shapes and distribution manners of the convex and concave structures in the contact region and the non-contact region are not particularly required or limited herein.

In a second aspect, the present disclosure provides a method for preparing the texture structure of a solar cell according to the first aspect, the method including a first texturing method or a second texturing method, wherein
the first texturing method includes: performing texturing and depositing on a surface of a silicon wafer to form a mask, removing the mask from a partial region to form a slot where a plane or a micro texture is prepared to form a contact region, removing all the mask so that a region covered by the mask forms a non-contact region and the texture structure is obtained; and
the second texturing method includes: performing primary texturing on a surface of a silicon wafer, performing fusion carving on a region where a metal gate line is to be located to form a contact region, covering the contact region with a mask, performing secondary texturing on a non-covered region to form a non-contact region, and removing all the mask to obtain the texture structure.

As an optional technical solution of the present disclosure, the first texturing method specifically includes:
(1) texturing the surface of the silicon wafer to form a texture, and depositing a mask on the texture;
(2) removing the mask from a partial region by laser to form a slot having the same shape as a metal gate line; and
(3) corroding the texture in a region of the slot with a corrosive solution to form a contact region, and then removing all the mask so that a region covered by the mask forms a non-contact region and the texture structure is obtained.

As an optional technical solution of the present disclosure, in the step (1), the depositing method includes PECVD.

Optionally, the mask includes silicon nitride.

Optionally, in the step (2), the slot has a width of 10 µm to 130 µm, for example, 10 µm, 20 µm, 30 µm, 40 µm, 50 µm, 60 µm, 70 µm, 80 µm, 90 µm, 100 µm, 110 µm, 120 µm or 130 µm, but is not limited to the recited values, and other values not recited in this range are also applicable.

Optionally, in the step (3), the corrosive solution includes an acid solution or an alkali solution.

Optionally, the acid solution includes a mixed solution of HF and HNO₃.

Optionally, the alkali solution includes a KOH solution or a NaOH solution.

Optionally, all the mask is removed with an HF solution.

As an optional technical solution of the present disclosure, the second texturing method specifically includes:
(I) performing a primary texturing on the surface of the silicon wafer to form the texture, and performing the fusion carving on the region where the metal gate line is to be located to form the contact region;
(II) performing high-temperature oxidation on the silicon wafer to form a silicon oxide layer on the surface, and then removing the silicon oxide layer; and
(III) printing a mask covered contact region on the surface of the silicon wafer, performing secondary texturing on the surface of the silicon wafer in a non-covered region to form a non-contact region, and removing the mask to obtain the texture structure.

As an optional technical solution of the present disclosure, in the step (I), the fusion carving is performed on a structure array by laser.

Optionally, in the step (II), the silicon oxide layer is removed by acid leaching.

Optionally, an acid solution used in the acid leaching includes HF.

Optionally, in the step (III), the mask has a printed width of 10 µm to 130 µm, for example, 10 µm, 20 µm, 30 µm, 40 µm, 50 µm, 60 µm, 70 µm, 80 µm, 90 µm, 100 µm, 110 µm, 120 µm or 130 µm, but is not limited to the recited values, and other values not recited in this range are also applicable.

Optionally, the mask is made of a material including paraffin.

Compared with the existing technology, the present disclosure has the following beneficial effects:

The present disclosure provides a texture structure of a solar cell, in which the texture of a metal gate line coverage region (contact region) and the texture of a metal gate line non-coverage region (non-contact region) form different microscopic appearances of texture structure, and the texture structure in the non-coverage region has a specific surface area much larger than the texture structure in the coverage region, thereby reducing a contact area between a slurry metal and a PN junction on the texture, reducing the metal recombination by more than 20%, and improving the conversion efficiency.

### BRIEF DESCRIPTION OF DRAWINGS

FIG. 1 is a schematic diagram of a texture structure according to Example 1 of the present disclosure;
FIG. 2 is a schematic diagram of a texture structure according to Example 2 of the present disclosure;
FIG. 3 is a schematic diagram of a texture structure according to Example 3 of the present disclosure;
FIG. 4 is a schematic diagram of a texture structure according to Example 4 of the present disclosure;
FIG. 5 is a schematic diagram of a texture structure according to Example 5 of the present disclosure;
FIG. 6 is a schematic diagram of a texture structure according to Example 6 of the present disclosure;
FIG. 7 is a schematic diagram of a texture structure according to Example 7 of the present disclosure;
FIG. 8 is a schematic diagram of a texture structure according to Example 8 of the present disclosure;
FIG. 9 is a schematic diagram of a texture structure according to Example 9 of the present disclosure; and
FIG. 10 is a schematic diagram of a texture structure according to Example 10 of the present disclosure.

### List of reference numerals:

1 - non-contact region; 2 - contact region; 3 - metal gate line; 4 - first pyramid protrusion; 5 - second pyramid protrusion; 6 - first inverted pyramid depression; 7 - second inverted pyramid depression; 8 - third pyramid protrusion; 9 - third inverted pyramid depression; 10 - undulant protrusion; 11 - pyramid protrusion; 12 - PN junction; and 13 - passivation layer.

### DETAIL DESCRIPTION OF EMBODIMENTS

It is to be understood that in the description of the present disclosure, the terms "central", "longitudinal", "lateral", "upper", "lower", "front", "rear", "left", "right", "vertical", "horizontal", "top", "bottom", "inner", "outer", and the like indicate an orientation or positional relationship based on the orientation or positional relationship shown in the drawings, and are merely used for facilitating and simplifying description of the present disclosure, instead of indicating or implying that the referred device or element is necessarily in a specific orientation, or constructed and operated in the specific orientation, and therefore, they should not be construed as limitations to the present disclosure. Furthermore, the terms "first", "second", and the like are used for descriptive purposes only and are not to be construed as indicating or implying relative importance or to implicitly indicate the number of the indicated technical features. Therefore, a feature defined by "first", "second" and the like may include one or more of the indicated feature either explicitly or implicitly. In the description of the present disclosure, "a plurality" means two or more unless otherwise specified.

The technical solution of the present disclosure is further explained below with specific embodiments in combination with the attached drawings.

### Example 1

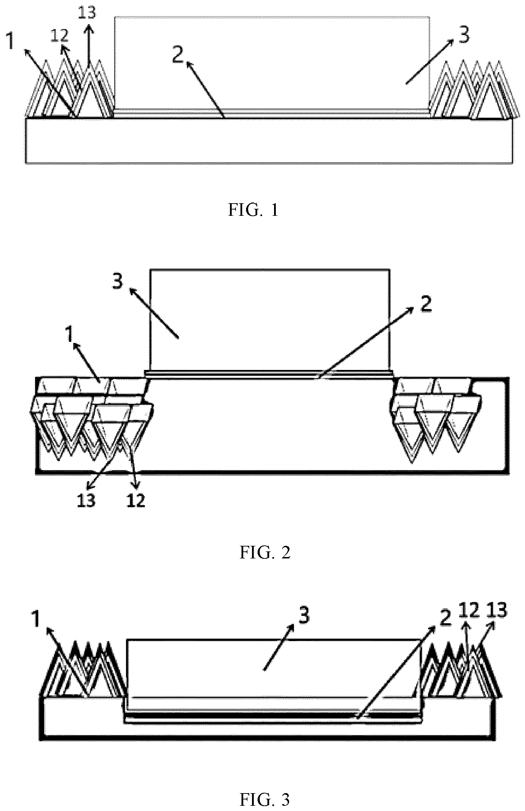

As shown in FIG. 1, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

A surface of the non-contact region 1 is an array of irregular pyramid structures, including pyramid protrusions across the region. The pyramid protrusions are different in size and distributed at random positions. A surface of the contact region 2 is a flat texture.

Specifically, as shown in FIG. 1, a plurality of pyramid protrusions are distributed on the surface of the non-contact region 1 of the texture, where each pyramid protrusion projects outwards from the surface of the non-contact region 1 of the texture, and the plurality of pyramid protrusions have random sizes and distribution positions, so that an array of irregular pyramid structures is formed, and each pyramid protrusion is provided with a PN junction 12 and a passivation layer 13 sequentially arranged in a stacked manner. The surface of the contact region 2 of the texture is a flat texture on which a PN junction 12 and a passivation layer 13 are sequentially arranged in a stacked manner, and the flat texture is provided with a metal gate line 3.

In Example 1, the texture in the contact region 2 has a reflectivity of 38%, and the texture in the non-contact region 1 has a reflectivity of 8%.

### Example 2

As shown in FIG. 2, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

A surface of the non-contact region 1 is an array of irregular pyramid structures, including inverted pyramid depressions across the region. The inverted pyramid depressions are different in size and distributed at random positions. A surface of the contact region 2 is a flat texture.

Specifically, as shown in FIG. 2, a plurality of inverted pyramid depressions are distributed on the surface of the non-contact region 1 of the texture, where each inverted pyramid depression is recessed inwards from the surface of the non-contact region 1 of the texture, and the plurality of inverted pyramid depressions have random sizes and distribution positions, so that an array of irregular pyramid structures is formed, and each inverted pyramid depression is provided with a PN junction 12 and a passivation layer 13 sequentially arranged in a stacked manner. The surface of the contact region 2 of the texture is a flat texture on which a PN junction 12 and a passivation layer 13 are sequentially arranged in a stacked manner, and the flat texture is provided with a metal gate line 3.

In Example 2, the texture in the contact region 2 has a reflectivity of 38%, and the texture in the non-contact region 1 has a reflectivity of 6%.

### Example 3

As shown in FIG. 3, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

A surface of the non-contact region 1 is an array of irregular pyramid structures, including pyramid protrusions across the region. The pyramid protrusions are different in size and distributed at random positions. A surface of the contact region 2 is a depressed flat texture.

Specifically, as shown in FIG. 3, a plurality of pyramid protrusions are distributed on the surface of the non-contact region 1 of the texture, where each pyramid protrusion projects outwards from the surface of the non-contact region 1 of the texture, and the plurality of pyramid protrusions have random sizes and distribution positions, so that an array of irregular pyramid structures is formed, and each pyramid protrusion is provided with a PN junction 12 and a passivation layer 13 sequentially arranged in a stacked manner. The surface of the contact region 2 of the texture being a depressed flat texture means that the surface of the contact region 2 of the texture is a flat texture depressed inwards from the surface of the non-contact region 1 of the texture. A PN junction 12 and a passivation layer 13 are sequentially arranged in a stacked manner on the depressed flat texture, and the depressed flat texture is provided with a metal gate line 3.

In Example 3, the texture in the contact region 2 has a reflectivity of 38%, and the texture in the non-contact region 1 has a reflectivity of 8%.

### Example 4

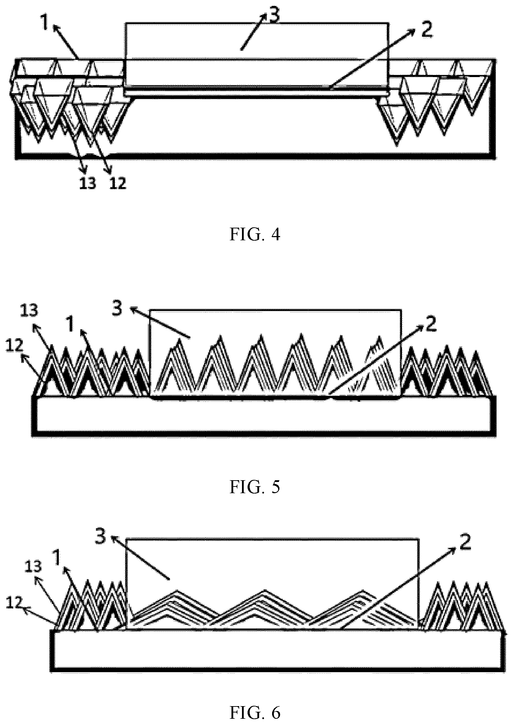

As shown in FIG. 4, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

A surface of the non-contact region 1 is an array of irregular pyramid structures, including inverted pyramid depressions across the region. The inverted pyramid depressions are different in size and distributed at random positions. A surface of the contact region 2 is a depressed flat texture.

Specifically, as shown in FIG. 4, a plurality of inverted pyramid depressions are distributed on the surface of the non-contact region 1 of the texture, where each inverted pyramid depression is recessed inwards from the surface of the non-contact region 1 of the texture, and the plurality of inverted pyramid depressions have random sizes and distribution positions, so that an array of irregular pyramid structures is formed, and each inverted pyramid depression is provided with a PN junction 12 and a passivation layer 13 sequentially arranged in a stacked manner. The surface of the contact region 2 of the texture being a depressed flat texture means that the surface of the contact region 2 of the texture is a flat texture depressed inwards from the surface of the non-contact region 1 of the texture. A PN junction 12 and a passivation layer 13 are sequentially arranged in a stacked manner on the depressed flat texture, and the depressed flat texture is provided with a metal gate line 3.

In Example 4, the texture in the contact region 2 has a reflectivity of 36%, and the texture in the non-contact region 1 has a reflectivity of 5%.

### Example 5

As shown in FIG. 5, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

The non-contact region 1 is an array of irregular pyramid structures, including pyramid protrusions across the region. The pyramid protrusions are different in size and distributed at random positions. The contact region 2 is an array of regular structures including multiple rows of strip-shaped protrusions parallel to each other. Each strip-shaped protrusion in the contact region 2 has a height greater than any of the pyramid protrusions in the non-contact region 1.

Specifically, as shown in FIG. 5, a plurality of pyramid protrusions are distributed on the surface of the non-contact region 1 of the texture, where each pyramid protrusion projects outwards from the surface of the non-contact region 1 of the texture, and the plurality of pyramid protrusions have random sizes and distribution positions, so that an array of irregular pyramid structures is formed, and each pyramid protrusion is provided with a PN junction 12 and a passivation layer 13 sequentially arranged in a stacked manner. The surface of the contact region 2 of the texture is provided with multiple rows of strip-shaped protrusions parallel to each other, where each strip-shaped protrusion projects outwards from the surface of the contact region 2 of the texture by a height greater than any pyramid protrusion projecting outwards from the surface of the non-contact region 1 of the texture. The multiple rows of strip-shaped protrusions parallel to each other form an array of regular structures, each strip-shaped protrusion is provided with a PN junction 12 and a passivation layer 13 sequentially arranged in a stacked manner, and the contact region 2 of the texture is provided with a metal gate line 3.

In Example 5, the texture in the contact region 2 has a reflectivity of 20%, and the texture in the non-contact region 1 has a reflectivity of 7%.

### Example 6

As shown in FIG. 6, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

The non-contact region 1 is an array of irregular pyramid structures, including pyramid protrusions across the region. The pyramid protrusions are different in size and distributed at random positions. The contact region 2 is an array of regular structures including multiple rows of strip-shaped protrusions parallel to each other. Each strip-shaped protrusion in the contact region 2 has a height smaller than any of the pyramid protrusions in the non-contact region 1.

Specifically, as shown in FIG. 6, a plurality of pyramid protrusions are distributed on the surface of the non-contact region 1 of the texture, where each pyramid protrusion projects outwards from the surface of the non-contact region 1 of the texture, and the plurality of pyramid protrusions have random sizes and distribution positions, so that an array of irregular pyramid structures is formed, and each pyramid protrusion is provided with a PN junction 12 and a passivation layer 13 sequentially arranged in a stacked manner. The surface of the contact region 2 of the texture is provided with multiple rows of strip-shaped protrusions parallel to each other, where each strip-shaped protrusion projects outwards from the surface of the contact region 2 of the texture by a height smaller than any pyramid protrusion projecting outwards from the surface of the non-contact region 1 of the texture. The multiple rows of strip-shaped protrusions parallel to each other form an array of regular structures, each strip-shaped protrusion is provided with a PN junction 12 and a passivation layer 13 sequentially arranged in a stacked manner, and the contact region 2 of the texture is provided with a metal gate line 3.

In Example 6, the texture in the contact region 2 has a reflectivity of 30%, and the texture in the non-contact region 1 has a reflectivity of 7%.

### Example 7

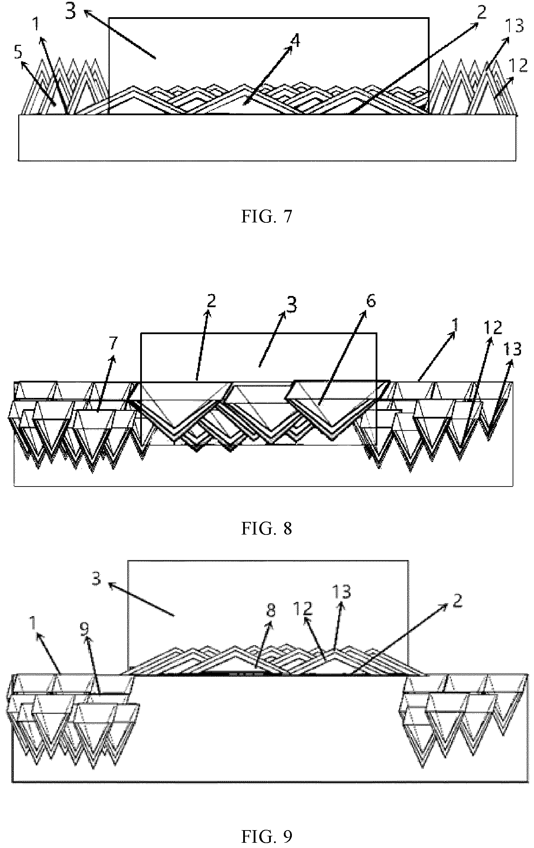

As shown in FIG. 7, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

Each of the non-contact region 1 and the contact region 2 is an array of irregular pyramid structures. The array of pyramid structures in the contact region 2 includes first pyramid protrusions 4 across the region, the array of pyramid structures in the non-contact region 1 includes second pyramid protrusions 5 across the region, and each first pyramid protrusion 4 has a height smaller than any of the second pyramid protrusions 5.

Specifically, as shown in FIG. 7, a plurality of second pyramid protrusions 5 are distributed on the surface of the non-contact region 1 of the texture, where each second pyramid protrusion 5 projects outwards from the surface of the non-contact region 1 of the texture, and the plurality of second pyramid protrusions 5 have random sizes and distribution positions, so that an array of irregular pyramid structures is formed, and each second pyramid protrusion 5 is provided with a PN junction 12 and a passivation layer 13 sequentially arranged in a stacked manner. A plurality of first pyramid protrusions 4 are distributed on the surface of the contact region 2 of the texture, where each first pyramid protrusion 4 projects outwards from the surface of the contact region 2 of the texture, and the plurality of first pyramid protrusions 4 have random sizes and distribution positions, so that an array of irregular pyramid structures is formed, each first pyramid protrusion 4 is provided with a PN junction 12 and a passivation layer 13 sequentially arranged in a stacked manner, and the contact region 2 of the texture is provided with a metal gate line 3. Each first pyramid protrusion 4 projects outwards from the surface of the contact region 2 of the texture by a height smaller than any second pyramid protrusion 5 projecting outwards from the surface of the non-contact region 1 of the texture.

In Example 7, the texture in the contact region 2 has a reflectivity of 25%, and the texture in the non-contact region 1 has a reflectivity of 7%.

### Example 8

As shown in FIG. 8, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

Each of the non-contact region 1 and the contact region 2 is an array of irregular pyramid structures. The array of pyramid structures in the contact region 2 includes first inverted pyramid depressions 6 across the region, the array of pyramid structures in the non-contact region 1 includes second inverted pyramid depressions 7 across the region, and each first inverted pyramid depression 6 has a depth smaller than any of the second inverted pyramid depressions 7.

Specifically, as shown in FIG. 8, a plurality of second inverted pyramid depressions 7 are distributed on the surface of the non-contact region 1 of the texture, where each second inverted pyramid depression 7 is recessed inwards from the surface of the non-contact region 1 of the texture, and the plurality of second inverted pyramid depressions 7 have random sizes and distribution positions, so that an array of irregular pyramid structures is formed, and each second inverted pyramid depression 7 is provided with a PN junction 12 and a passivation layer 13 sequentially arranged in a stacked manner. A plurality of first inverted pyramid depressions 6 are distributed on the surface of the contact region 2 of the texture, where each first inverted pyramid depression 6 is recessed inwards from the surface of the contact region 2 of the texture, and the plurality of first inverted pyramid depressions 6 have random sizes and distribution positions, so that an array of irregular pyramid structures is formed, each first inverted pyramid depression 6 is provided with a PN junction 12 and a passivation layer 13 sequentially arranged in a stacked manner, and the contact region 2 of the texture is provided with a metal gate line 3. Each first inverted pyramid depression 6 is recessed inwards from the surface of the contact region 2 of the texture by a depth smaller than any second inverted pyramid depression 7 recessed inwards from the surface of the non-contact region 1 of the texture.

In Example 8, the texture in the contact region 2 has a reflectivity of 15%, and the texture in the non-contact region 1 has a reflectivity of 5%.

### Example 9

As shown in FIG. 9, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

The array of pyramid structures in the contact region 2 includes third pyramid protrusions 8 across the region, the array of pyramid structures in the non-contact region 1 includes third inverted pyramid depressions 9 across the region, and each third pyramid protrusion 8 has a height smaller than a depth of any of the third inverted pyramid depressions 9.

Specifically, as shown in FIG. 9, a plurality of third inverted pyramid depressions 9 are distributed on the surface of the non-contact region 1 of the texture, where each third inverted pyramid depression 9 is recessed inwards from the surface of the non-contact region 1 of the texture, and the plurality of third inverted pyramid depressions 9 have random sizes and distribution positions, so that an array of irregular pyramid structures is formed, and each third inverted pyramid depression 9 is provided with a PN junction 12 and a passivation layer 13 sequentially arranged in a stacked manner. A plurality of third pyramid protrusions 8 are distributed on the surface of the contact region 2 of the texture, where each third pyramid protrusion 8 projects outwards from the surface of the contact region 2 of the texture, and the plurality of third pyramid protrusions 8 have random sizes and distribution positions, so that an array of irregular pyramid structures is formed, each third pyramid protrusion 8 is provided with a PN junction 12 and a passivation layer 13 sequentially arranged in a stacked manner, and the contact region 2 of the texture is provided with a metal gate line 3. Each third pyramid protrusion 8 projects outwards from the surface of the contact region 2 of the texture by a height smaller than a depth by which any third inverted pyramid depression 9 is recessed inwards from the surface of the non-contact region 1 of the texture.

In Example 9, the texture in the contact region 2 has a reflectivity of 25%, and the texture in the non-contact region 1 has a reflectivity of 5%.

### Example 10

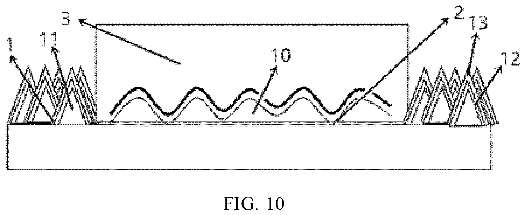

As shown in FIG. 10, this example provides a texture structure of a solar cell, including a texture with a surface on which a PN junction 12 and a passivation layer 13 are sequentially arranged in a stacked manner. The surface of the texture includes a contact region 2 and a non-contact region 1. The contact region 2 is provided with a metal gate line 3.

A surface of the contact region 2 forms undulant protrusions 10 across the region, a surface of the non-contact region 1 forms irregular pyramid protrusions 11, and each undulant protrusion 10 has a height smaller than any of the pyramid protrusions 11.

Specifically, as shown in FIG. 10, a plurality of pyramid protrusions 11 are distributed on the surface of the non-contact region 1 of the texture, where each pyramid protrusion 11 projects outwards from the surface of the non-contact region 1 of the texture, and the plurality of pyramid protrusions 11 have random sizes and distribution positions, so that an array of irregular pyramid structures is formed, and each pyramid protrusion 11 is provided with a PN junction 12 and a passivation layer 13 sequentially arranged in a stacked manner. The surface of the contact region 2 of the texture is provided with undulant protrusions 10 each projecting outwards from the surface of the contact region 2 of the texture, and the contact region 2 of the texture is provided with a metal gate line 3. Each undulant protrusion 10 projects outwards from the surface of the contact region 2 of the texture by a height smaller than any pyramid protrusion 11 projecting outwards from the surface of the non-contact region 1 of the texture.

In Example 10, the texture in the contact region 2 has a reflectivity of 35%, and the texture in the non-contact region 1 has a reflectivity of 8%.

In a further example of the present disclosure, the texture structure includes a texture with a surface on which a PN junction 12 and a passivation layer 13 are sequentially arranged in a stacked manner, the surface of the texture includes a contact region 2 and a non-contact region 1, and the contact region 2 is provided with a metal gate line 3. The array of irregular structures in the contact region includes fourth inverted pyramid depressions across the region, the array of irregular structures in the non-contact region includes fourth pyramid protrusions across the region, and each fourth inverted pyramid depression has a depth smaller than a height of any of the fourth pyramid protrusions. that is to say, in this further example of the present disclosure, a plurality of fourth pyramid protrusions are distributed on the surface of the non-contact region 1 of the texture, where each fourth pyramid protrusion projects outwards from the surface of the non-contact region 1 of the texture, and the plurality of fourth pyramid protrusions have random sizes and distribution positions, so that an array of irregular pyramid structures is formed, and each fourth pyramid protrusion is provided with a PN junction 12 and a passivation layer 13 sequentially arranged in a stacked manner. A plurality of fourth inverted pyramid depressions are distributed on the surface of the contact region 2 of the texture, where each fourth inverted pyramid depression is recessed inwards from the surface of the contact region 2 of the texture, and the plurality of fourth inverted pyramid depressions have random sizes and distribution positions, so that an array of irregular pyramid structures is formed, each fourth inverted pyramid depression is provided with a PN junction 12 and a passivation layer 13 sequentially arranged in a stacked manner, and the contact region 2 of the texture is provided with a metal gate line 3. Each fourth inverted pyramid depression is recessed inwards from the surface of the contact region 2 of the texture by a depth smaller than a height by which any fourth pyramid protrusion projects outwards from the surface of the non-contact region 1 of the texture.

### Example 11

This example provides a method for preparing the texture structure of Example 1, which specifically includes:
(1) texturing a surface of a silicon wafer to form a texture, and depositing a SiNₓ mask on the texture through a plasma enhanced chemical vapor deposition (PECVD) process;
(2) removing the mask from a partial region by laser to form a slot having the same shape as a metal gate line 3; and
(3) corroding the texture in a region of the slot with a mixed solution of HF and HNO₃ to form a contact region 2, and then removing all the mask with an HF solution so that a region covered by the mask forms a non-contact region 1 and the texture structure is obtained.

### Example 12

This example provides a method for preparing the texture structure of Example 1, which specifically includes:
(1) performing a primary texturing on a surface of a silicon wafer to form a texture, and performing fusion carving on a region where a metal gate line 3 is to be located to form a contact region 2;
(2) performing high-temperature oxidation on the silicon wafer to form a silicon oxide layer on the surface, and removing the silicon oxide layer with HF; and
(3) printing a mask covered contact region 2 on the surface of the silicon wafer, performing secondary texturing on the surface of the silicon wafer to form a non-contact region 1, and removing the mask to obtain the texture structure.

In summary, according to the texture structure of a solar cell provided in the examples of the present disclosure, the texture of a metal gate line coverage region (contact region) and the texture of a metal gate line non-coverage region (non-contact region) form different microscopic appearances of texture structure, and the texture structure in the non-coverage region has a specific surface area much larger than the texture structure in the coverage region, thereby reducing a contact area between a slurry metal and a PN junction on the texture, reducing the metal recombination by more than 20%, and improving the conversion efficiency.

The applicant declares that the above describes merely specific embodiments of the present disclosure, and the protection scope of the present disclosure is not limited thereto, and it should be understood by those skilled in the art that any changes or substitutions that can be easily conceived by those skilled in the art within the technical scope of the present disclosure disclosed herein fall within the protection scope and disclosure of the present disclosure.

## Claims

1. A texture structure of a solar cell, **characterized in that** the texture structure comprises a texture with a surface comprising a contact region and a non-contact region, wherein the contact region is provided with a metal gate line, and has a specific surface area smaller than the non-contact region.

2. The texture structure according to claim 1, **characterized in that** a PN junction and a passivation layer are sequentially arranged in a stacked manner on the surface of the texture, and the metal gate line is located on a surface of the passivation layer corresponding to the contact region; and
the texture in the contact region has a greater reflectivity than the texture in the non-contact region.

3. The texture structure according to claim 2, **characterized in that** the texture in the contact region has a reflectivity of 8% to 46%; and the texture in the non-contact region has a reflectivity of 5% to 14%.

4. The texture structure according to any one of claims 1 to 3, **characterized in that** a surface of the non-contact region is an array of irregular structures, and a surface of the contact region is a flat texture; and
the array of irregular structures comprises pyramid protrusions or inverted pyramid depressions across the region, wherein the pyramid protrusions or the inverted pyramid depressions are different in size and distributed at random positions.

5. The texture structure according to claim 4, **characterized in that** the contact region is a depressed flat texture.

6. The texture structure according to any one of claims 1 to 3, **characterized in that** the non-contact region is an array of irregular structures, and the contact region is an array of regular structures;
the array of irregular structures comprises pyramid protrusions or inverted pyramid depressions across the region, wherein the pyramid protrusions or the inverted pyramid depressions are different in size and distributed at random positions; and
the array of regular structures comprises at least two rows of strip-shaped protrusions or strip-shaped grooves parallel to each other.

7. The texture structure according to any one of claims 1 to 3, **characterized in that** each of the non-contact region and the contact region is an array of irregular structures;
the array of irregular structures in the contact region comprises first pyramid protrusions across the region, the array of irregular structures in the non-contact region comprises second pyramid protrusions across the region, and each first pyramid protrusion has a height smaller than any of the second pyramid protrusions;
or, the array of irregular structures in the contact region comprises first inverted pyramid depressions across the region, the array of irregular structures in the non-contact region comprises second inverted pyramid depressions across the region, and each first inverted pyramid depression has a depth smaller than any of the second inverted pyramid depressions;
or, the array of irregular structures in the contact region comprises third pyramid protrusions across the region, the array of irregular structures in the non-contact region comprises third inverted pyramid depressions across the region, and each third pyramid protrusion has a height smaller than a depth of any of the third inverted pyramid depressions;
or, the array of irregular structures in the contact region comprises fourth inverted pyramid depressions across the region, the array of irregular structures in the non-contact region comprises fourth pyramid protrusions across the region, and each fourth inverted pyramid depression has a depth smaller than a height of any of the fourth pyramid protrusions.

8. The texture structure according to any one of claims 1 to 3, **characterized in that** a surface of the contact region forms undulant protrusions across the region, a surface of the non-contact region forms irregular pyramid protrusions, and each undulant protrusion has a height smaller than any of the pyramid protrusions.

9. A method for preparing the texture structure of a solar cell according to any one of claims 1 to 8, **characterized in** comprising a first texturing method or a second texturing method, wherein
the first texturing method comprises: perform texturing and depositing on a surface of a silicon wafer to form a mask, removing the mask from a partial region to form a slot where a plane or a micro texture is prepared to form a contact region, removing all the mask so that a region covered by the mask forms a non-contact region and the texture structure is obtained; and
the second texturing method comprises: performing primary texturing on a surface of a silicon wafer, performing fusion carving on a region where a metal gate line is to be located to form a contact region, covering the contact region with a mask, performing secondary texturing on a non-covered region to form a non-contact region, and removing all the mask to obtain the texture structure.

10. The method according to claim 9, **characterized in that** the first texturing method specifically comprises:
(1) texturing the surface of the silicon wafer to form a texture, and depositing a mask on the texture;
(2) removing the mask from a partial region by laser to form a slot having the same shape as a metal gate line; and
(3) corroding the texture in a region of the slot with a corrosive solution to form a contact region, and then removing all the mask so that a region covered by the mask forms a non-contact region and the texture structure is obtained.

11. The method according to claim 10, **characterized in that** in the step (1), the depositing method comprises PECVD; and the mask comprises silicon nitride.

12. The method according to claim 10, **characterized in that** in the step (2), the slot has a width of 10 µm to 130 µm.

13. The method according to claim 10, **characterized in that** in the step (3), the corrosive solution comprises an acid solution or an alkali solution; the acid solution comprises a mixed solution of HF and HNO₃; the alkali solution comprises a KOH solution or a NaOH solution; and all the mask is removed with an HF solution.

14. The method according to claim 9, **characterized in that** the second texturing method specifically comprises:
(I) performing a primary texturing on the surface of the silicon wafer to form the texture, and performing the fusion carving on the region where the metal gate line is to be located to form the contact region;
(II) performing high-temperature oxidation on the silicon wafer to form a silicon oxide layer on the surface, and then removing the silicon oxide layer; and
(III) printing a mask covered contact region on the surface of the silicon wafer, performing secondary texturing on the surface of the silicon wafer in a non-covered region to form the non-contact region, and removing the mask to obtain the texture structure.

15. The method according to claim 14, **characterized in that** in the step (I), the fusion carving is performed on a structure array by laser.

16. The method according to claim 14, **characterized in that** in the step (II), the silicon oxide layer is removed by acid leaching, and an acid solution used in the acid leaching comprises HF.

17. The method according to claim 14, **characterized in that** in the step (III), the mask has a printed width of 10 µm to 130 µm; and the mask is made of a material comprising paraffin.
